# EUROPEAN PATENT APPLICATION

(11) **EP 2 796 858 A1**
(43) Date of publication of application: **29.10.2014**
(21) Application number: 14165589.4
(22) Date of filing: 23.04.2014
(51) Int. Cl.: G01N 21/63, G01N 25/72, G01J 3/10, G01N 21/71, B23K 31/12

(54) **Optical non-destructive inspection apparatus and optical non-destructive inspection method**

(30) Priority: 26.04.2013 JP 2013093850
(71) Applicant: JTEKT CORPORATION, Osaka-shi Osaka 542-8502 (JP)
(72) Inventor: Matsumoto, Naoki, Osaka-shi, Osaka 542-8502 (JP); Yoshida, Kouya, Osaka-shi, Osaka 542-8502 (JP); Matsumoto, Jun, Osaka-shi, Osaka 542-8502 (JP)
(74) Representative: Winter, Brandl, Fürniss, Hübner, Röss, Kaiser, Polte - Partnerschaft mbB

(57) **Abstract**

There are provided an optical non-destructive inspection apparatus which can inspect a measurement object such as a wire bonding portion in a broad measurable temperature range in a short time, with high reliability, and an optical non-destructive inspection method using it. The apparatus includes a focusing-collimating unit (10), a heating laser beam source (21), a heating laser beam guide unit, an infrared detector (31), an emitted-infrared guide unit, a correcting laser beam sources (22), a correcting laser beam guide unit, a correcting laser detector (32), a reflected laser beam guide unit, and a control unit (50). The control unit (50) controls the heating laser beam source (21) and the correcting laser beam source (22), measures a temperature rise characteristic that is a temperature rise state of a measurement spot (SP) based on a heating time, on the basis of a detection signal from the infrared detector (31) and a detection signal from the correcting laser detector (32), and determines a state of a measurement object (bonding structure (97)) based on the measured temperature rise characteristic.

## Description

### BACKGROUND OF THE INVENTION

### 1. Field of the Invention

The present invention relates to an optical non-destructive inspection apparatus and an optical non-destructive inspection method.

### 2. Description of Related Art

When an electrode is bonded to a semiconductor chip by wire bonding, the electrode and a wire can be bonded using various methods and it is necessary to inspect whether the electrode and the wire are appropriately bonded to each other. Conventionally, an operator visually inspects a bonding part while the bonding part is enlarged with a microscope or the like, or extracts a predetermined sample, destroys an electrode and a wire to inspect strength thereof or the like. When the bonding part is inspected visually by an operator, reliability of inspection results is low and inspection efficiency is low, because there may be difference in a skill level among operators, or the skill level of one operator may vary due to fatigue, a physical condition, or the like. When destructive inspection is performed on an extracted sample, it is not possible to assure that all the other objects that are not samples and are not actually destroyed (all the other objects that are not extracted) are in the same state as the state of the destroyed sample.

Therefore, in a conventional technology described in Japanese Patent Application Publication No. 2011-191232 (JP 2011-191232 A), a method and an apparatus are described, which determine whether the state of wire bonding with the use of a small-diameter wire is appropriate. In the technology, in order to determine whether the state of wire bonding is appropriate in a non-contact manner on the basis of an area of a bonding part, a target position of a wire is heated with a laser beam, a small amount of an infrared light beam emitted from the heated position is measured by using a two-wavelength infrared emission thermometer, a temperature variation up to a saturated temperature is measured, a numerical value correlated with the area of the bonding part is determined on the basis of the temperature variation, and it is determined whether the bonding state is appropriate on the basis of the numerical value. In this technology, a temperature rise state until the temperature reaches the saturated temperature due to heating is measured, and infrared light beams with two different wavelengths are used to measure the temperature. Correction using the reflectance or emissivity of a measurement spot is not performed. In the method using a ratio between infrared light beams with two different wavelengths, actually, measurement accuracy and a measurable temperature range are determined depending on what wavelengths are selected as the two wavelengths of the infrared light beams.

In a technology described in Japanese Patent Application Publication No. 2008-145344 (JP 2008-145344 A), a small metal bonding part evaluation method is described, in which a bonding part is heated up to a predetermined temperature with a laser beam, a temperature falling state after stoppage of irradiation with a laser beam is measured by using a temperature-measuring infrared sensor, and it is determined whether a bonding state is appropriate on the basis of the temperature falling state. Further, a reflectance-measuring laser beam and a reflectance-measuring infrared sensor are provided, and reflectance is measured to correct the measured temperature falling state. In the technology, the result of irradiation with a reflectance-measuring laser beam is detected by using the reflectance-measuring infrared sensor. That is, in order to measure the reflectance, an object is heated with the reflectance-measuring laser beam. Thus, the object is heated with the reflectance-measuring laser beam in addition to being heated with the original heating laser beam. Accordingly, the temperature fall characteristic as the measurement result is influenced by the change in the temperature due to the reflectance-measuring laser beam. Thus, it is doubtful whether appropriate correction is performed. The time until the temperature reaches the saturated temperature during heating is generally several tens of ms, but the temperature falling time after heating is generally several tens of seconds to several minutes. Accordingly, in the technology in which the temperature falling time is measured, the inspection time is extremely long, which is not preferable.

In another conventional technology described in Japanese Patent No. 4857422, a thermophysical property measuring method and a thermophysical property measuring apparatus are described, in which a sample is fused and floated in a high-frequency coil in a vacuum chamber, a fundamental equation of heat conduction that appropriately represents a method of measuring a thermophysical property value using laser heating is derived, and actual thermophysical property of a conductive material fused at a high temperature can be directly measured. This technology is a method in which a sample is fused and floated by using a large-scaled apparatus and cannot be applied to inspection of the state of wire bonding.

### SUMMARY OF THE INVENTION

An object of the present invention is to provide an optical non-destructive inspection apparatus and an optical non-destructive inspection method, in which a measurement object such as a wire bonding portion can be inspected in a broader measurable temperature range in a shorter time, with higher reliability.

An aspect of the present invention relates to an optical non-destructive inspection apparatus. The optical non-destructive inspection apparatus includes a focusing-collimating unit that that emits parallel light, which is incident from a first side along an optical axis, from a second side, focuses the parallel light to a measurement spot set on a measurement object as a focal position, converts light, which is emitted and reflected from the measurement spot and incident from the second side, into parallel light along the optical axis, and emits the parallel light from the first side; a heating laser beam source that emits a heating laser beam for heating the measurement object without destroying the measurement object; a heating laser beam guide unit that guides the heating laser beam to the first side of the focusing-collimating unit; an infrared detector that detects an infrared light beam emitted from the measurement spot; an emitted-infrared guide unit that guides an infrared light beam with a predetermined infrared wavelength out of the parallel light emitted from the measurement spot and emitted from the first side of the focusing-collimating unit, to the infrared detector; a correcting laser beam source that emits a correcting laser beam having output power smaller than that of the heating laser beam, and having a correcting laser wavelength different from a heating laser wavelength of the heating laser beam; a correcting laser beam guide unit that guides the correcting laser beam to the first side of the focusing-collimating unit; a correcting laser detector that detects the correcting laser beam reflected by the measurement spot; a reflected laser beam guide unit that guides the correcting laser beam reflected by the measurement spot and emitted from the first side of the focusing-collimating unit, to the correcting laser detector; and a control unit. The control unit controls the heating laser beam source and the correcting laser beam source, measures a temperature rise characteristic based on a detection signal from the infrared detector and a detection signal from the correcting laser detector, and determines a state of the measurement object based on the measured temperature rise characteristic, the temperature rise characteristic being a temperature rise state of the measurement spot based on a heating time.

In this aspect, since the temperature rise characteristic of the measurement object during heating is measured, inspection can be performed in a shorter time. Further, since the correcting laser beam itself, which is reflected by the measurement spot, is detected by the correcting laser detector instead of detecting an infrared light beam due to the correcting laser beam, it is not necessary to heat the measurement object with the correcting laser beam. Accordingly, irradiation is performed with the correcting laser beam whose output is small enough not to affect heating with the heating laser beam. Therefore, the measurement result is not influenced by the change in the temperature due to the reflectance-measuring laser beam, and thus, it is possible to detect a more accurate temperature.

Further, since the temperature detected by using the infrared detector is corrected based on the detection signal from the correcting laser detector, it is possible to perform the measurement in a broader temperature range, as compared to the case in which the temperature is determined based on a ratio between infrared light beams with two different wavelengths. Further, it is possible to stably perform inspection with higher reliability without an influence of the skill level, physical condition, or the like of an operator.

According to another aspect of the present invention, in the optical non-destructive inspection apparatus according to the above-mentioned aspect, the heating laser beam guide unit includes a heating laser beam collimating unit that is disposed in vicinity of the heating laser beam source, and converts the heating laser beam emitted from the heating laser beam source into parallel light; and a heating-laser selective reflection unit that is disposed on the optical axis of the focusing-collimating unit, reflects the heating laser beam to the first side of the focusing-collimating unit, and transmits a light beam with a wavelength different from the heating laser wavelength of the heating laser beam out of the parallel light emitted and reflected from the measurement spot and emitted from the first side of the focusing-collimating unit; or a heating-laser selective reflection unit that is disposed on the optical axis of the focusing-collimating unit, transmits the heating laser beam to the first side of the focusing-collimating unit, and reflects the light beam with the wavelength different from the heating laser wavelength of the heating laser beam out of the parallel light emitted and reflected from the measurement spot and emitted from the first side of the focusing-collimating unit. In this aspect, it is possible to appropriately realize the heating laser beam guide unit.

According to yet another aspect of the present invention, in the optical non-destructive inspection apparatus according to the above-mentioned aspect, the emitted-infrared guide unit includes the heating-laser selective reflection unit; a predetermined-infrared selective reflection unit that is disposed in a path of parallel light that is emitted from the first side of the focusing-collimating unit and transmitted or reflected by the heating-laser selective reflection unit and has a wavelength different from the heating laser wavelength of the heating laser beam, the predetermined-infrared selective reflection unit transmitting the infrared light beam with the predetermined infrared wavelength out of the parallel light toward the infrared detector, and reflecting the parallel light with a wavelength different from the predetermined infrared wavelength, or a predetermined-infrared selective reflection unit disposed in the path of the parallel light that is emitted from the first side of the focusing-collimating unit and transmitted or reflected by the heating-laser selective reflection unit and has the wavelength different from the heating laser wavelength, the predetermined-infrared selective reflection unit reflecting the infrared light beam with the predetermined infrared wavelength out of the parallel light toward the infrared detector, and transmitting the parallel light with the wavelength different from the predetermined infrared wavelength; and an infrared focusing unit that is disposed in vicinity of the infrared detector, and focuses the infrared light beam with the predetermined infrared wavelength transmitted or reflected by the predetermined-infrared selective reflection unit, to the infrared detector, the infrared light beam with the predetermined infrared wavelength being parallel light. In this aspect, it is possible to appropriately realize the emitted-infrared guide unit.

According to yet another aspect of the present invention, in the optical non-destructive inspection apparatus according to the above-mentioned aspect, the correcting laser beam guide unit includes a correcting laser beam collimating unit that is disposed in vicinity of the correcting laser beam source, and converts the correcting laser beam emitted from the correcting laser beam source into parallel light; a beam splitter that reflects a light beam with the correcting laser wavelength at a predetermined first proportion, transmits the light beam with the correcting laser wavelength at a predetermined second proportion, and reflects or transmits the correcting laser beam with the correcting laser wavelength, which is emitted from the correcting laser beam source and converted into the parallel light, toward the predetermined-infrared selective reflection unit so that the correcting laser beam with the correcting laser wavelength overlaps with parallel light with a wavelength different from the predetermined infrared wavelength; the predetermined-infrared selective reflection unit; and the heating-laser selective reflection unit. The reflected laser beam guide unit includes the heating-laser selective reflection unit; the predetermined-infrared selective reflection unit; the beam splitter; and a reflected laser beam focusing unit that is disposed in vicinity of the correcting laser detector, and focuses a light beam with the correcting laser wavelength reflected from the measurement spot and transmitted or reflected by the beam splitter in a direction different from a direction toward the correcting laser beam source, to the correcting laser detector. In this aspect, it is possible to appropriately realize the correcting laser beam guide unit and the reflected laser beam guide unit.

According to yet another aspect of the present invention, in the optical non-destructive inspection apparatus according to the above-mentioned aspect, the control unit acquires the detection signal from the infrared detector while controlling the heating laser beam source so as to heat the measurement spot with the heating laser beam, acquires the detection signal from the correcting laser detector while controlling the correcting laser beam source so as to irradiate the measurement spot with the correcting laser beam, measures a reflectance of the measurement spot based on the detection signal acquired from the correcting laser detector, corrects a detected value acquired from the infrared detector based on the measured reflectance, determines a temperature based on the corrected detected value, and determines the state of the measurement object based on the temperature rise characteristic that is based on the determined temperature and the heating time.

In this aspect, the reflectance of the measurement spot is measured by detecting the correcting laser beam itself reflected from the measurement spot, without performing heating with the correcting laser beam. Then, the temperature rise characteristic is determined based on the temperature corrected based on the measured reflectance. Therefore, it is possible to obtain a more accurate temperature rise characteristic. Accordingly, it is possible to stably perform the inspection with higher reliability, without an influence of the skill level, physical condition, or the like of an operator.

According to yet another aspect of the present invention, in the optical non-destructive inspection apparatus according to the above-mentioned aspect, the control unit acquires the detection signal from the correcting laser detector while controlling the correcting laser beam source so as to irradiate the measurement spot with the correcting laser beam, measures a reflectance of the measurement spot based on the detection signal acquired from the correcting laser detector, adjusts output power of the heating laser beam from the heating laser beam source based on the measured reflectance, acquires the detection signal from the infrared detector while heating the measurement spot with the heating laser beam whose output power has been adjusted, determines a temperature based on the detection signal acquired from the infrared detector, and determines the state of the measurement object based on the temperature rise characteristic that is based on the determined temperature and the heating time.

In this aspect, the reflectance of the measurement spot is measured by detecting the correcting laser beam itself reflected from the measurement spot, without performing heating with the correcting laser beam. Then, the output of the heating laser beam is adjusted based on the measured reflectance. Therefore, it is possible to provide energy used for heating the measurement spot more accurately, and thus, it is possible to determine a more accurate temperature rise characteristic. Accordingly, it is possible to stably perform the inspection with higher reliability, without an influence of the skill level, physical condition, or the like of an operator.

According to yet another aspect of the present invention, in the optical non-destructive inspection apparatus according to the above-mentioned aspect, the measurement object is a bonding structure including a bonding part in which two members are bonded, the measurement spot is set on a surface of one member of the two members, and the control unit determines a bonding state of the two members based on the temperature rise characteristic. In this aspect, for example, when the two members are an electrode and a wire, the optical non-destructive inspection apparatus can be appropriately used to determine the bonding state of the electrode and the wire.

According to yet another aspect of the present invention, in the optical non-destructive inspection apparatus according to the above-mentioned aspect, the bonding state of the two members to be determined is a magnitude of an area of the bonding part of the two members, and the control unit determines whether the area of the bonding part of the two members is in an allowable range, based on the temperature rise characteristic. In this aspect, for example, when the two members are an electrode and a wire, it is determined whether the area of the bonding part of the electrode and the wire is in the allowable range, based on the temperature rise characteristic. Therefore, it is possible to more appropriately determine whether the bonding state of the electrode and the wire is appropriate.

Yet another aspect of the present invention relates to an optical non-destructive inspection method, in which the optical non-destructive inspection apparatus according to any one of the above-mentioned aspects is used, and the state of the measurement object is determined by the control unit. In this aspect, it is possible to provide the optical non-destructive inspection method in which the measurement object such as a wire bonding portion can be inspected in a broader measurable temperature range in a shorter time, with higher reliability.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1A is a diagram illustrating an example of a measurement object, and FIG. 1B is a diagram illustrating an example of a state in which a wire is bonded to an electrode through wire bonding;
FIG. 2 is a diagram illustrating an example of a configuration of an optical non-destructive inspection apparatus according to a first embodiment;
FIG. 3 is a diagram illustrating an example of a configuration of an optical non-destructive inspection apparatus according to a second embodiment;
FIG. 4 is a diagram illustrating an example of a configuration of an optical non-destructive inspection apparatus according to a third embodiment;
FIG. 5 is a diagram illustrating an example of a configuration of an optical non-destructive inspection apparatus according to a fourth embodiment;
FIG. 6 is a flowchart illustrating an example of a procedure of first processing in the optical non-destructive inspection apparatus;
FIG. 7 is a diagram illustrating a reflectance characteristic;
FIG. 8 is a diagram illustrating a relationship among a wavelength of an infrared light beam, energy of the infrared light beam, and a temperature;
FIG. 9 is a diagram illustrating an example of a temperature rise characteristic based on a corrected temperature obtained by performing correction by using a reflectance;
FIG. 10 is a diagram illustrating an example in which it is determined whether an area of a bonding part is in an allowable range, using the temperature rise characteristic; and
FIG. 11 is a flowchart illustrating an example of a procedure of second processing in the optical non-destructive inspection apparatus.

### DETAILED DESCRIPTION OF EMBODIMENTS

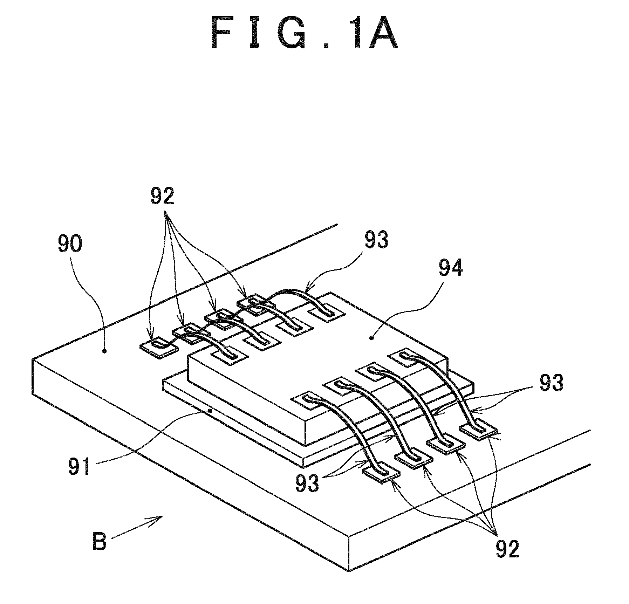

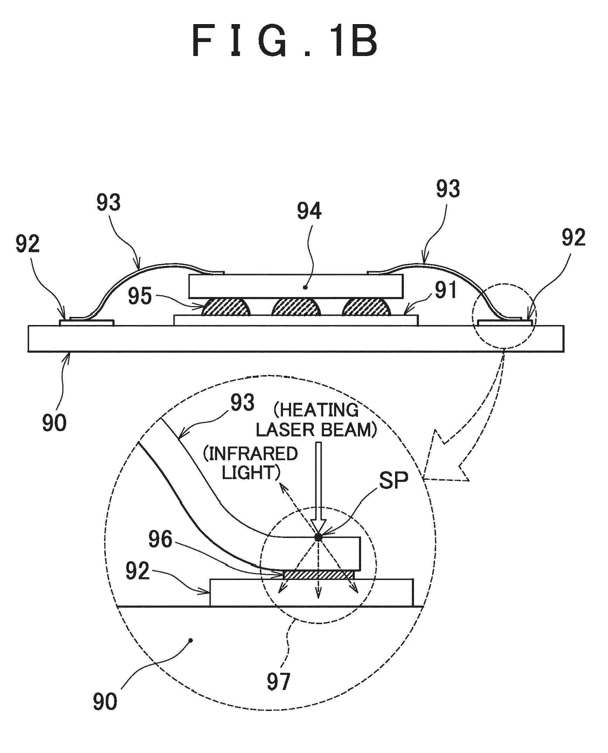

Hereinafter, embodiments of the present invention will be described with reference to the accompanying drawings. An example of a measurement object will be described with reference to FIGS. 1A and 1B. FIG. 1A is a perspective view of a board 90. A first end of a wire 93 that is formed of aluminum or the like and that has a diameter of several tens of µm to several hundreds of µm is mechanically and electrically bonded to each electrode 92 disposed on the board 90 through wire bonding, and a second end of the wire 93 is bonded to each terminal of a semiconductor chip 94 fixed onto the board 90. FIG. 1B is a view of FIG. 1A when viewed in a direction B. In this embodiment, a bonding structure 97 including a bonding part 96 in which the wire 93 and the electrode 92 are bonded to each other is described as a measurement object.

In order to determine whether the wire 93 is appropriately bonded to the electrode 92, it may be determined whether a bonding state is appropriate based on whether the area of the bonding part 96, that is, the area of a region, in which the surface of the wire 93 and the surface of the electrode 92 are parallel to each other in FIG. 1B, is in an allowable range. Therefore, as illustrated in the enlarged view of the bonding structure 97 in FIG. 1B, a measurement spot SP is set on the surface of the wire 93 of the bonding structure 97 and the measurement spot SP is irradiated and heated with a heating laser beam. Then, the temperature of the measurement spot SP gradually rises and heat transfers from the measurement spot SP to the electrode 92 via the inner portion of the wire 93 and the bonding part 96. An infrared light beam corresponding to the raised temperature is emitted from the bonding structure 97 including the measurement spot SP.

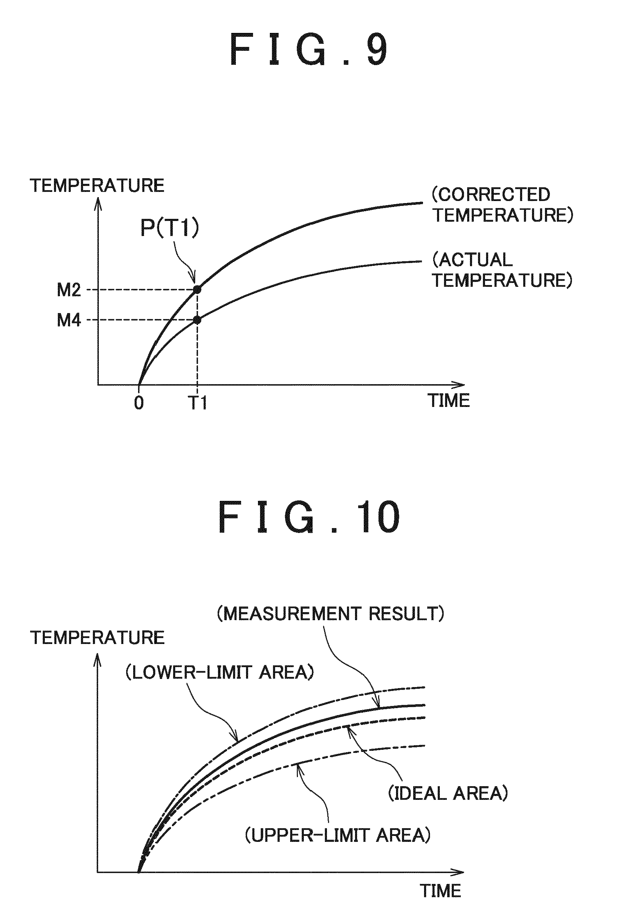

The temperature of the measurement spot SP gradually rises, and when the temperature reaches a saturated temperature at which the quantity of heat added and the quantity of heat dissipated are equal to each other, the rise in temperature stops and then, the temperature becomes substantially constant in spite of continuous heating. When the area of the bonding part 96 is relatively large, the quantity of heat transferring to the electrode 92 is large, and therefore, the temperature rises relatively gradually with the lapse of a heating time, and the saturated temperature is relatively low. When the area of the bonding part 96 is relatively small, the quantity of heat transferring to the electrode 92 is small, and therefore, the temperature rises relatively sharply with the lapse of the heating time, and the saturated temperature is raised (see FIG. 9). Thus, it is possible to determine whether the bonding state is appropriate by irradiating the measurement spot SP with a heating laser beam, measuring the temperature rise characteristic illustrated in FIG. 9, determining the area of the bonding part 96 on the basis of the temperature rise characteristic, and determining whether the determined area of the bonding part 96 is in an allowable range.

Hereinafter, details of optical non-destructive inspection apparatuses 1A to 1D and an optical non-destructive inspection method that can determine whether the bonding state is appropriate will be described. In the first to fourth embodiments, elements are the same but arrangement positions of the elements, a reflection direction, or a transmission direction, or the like is/are different.

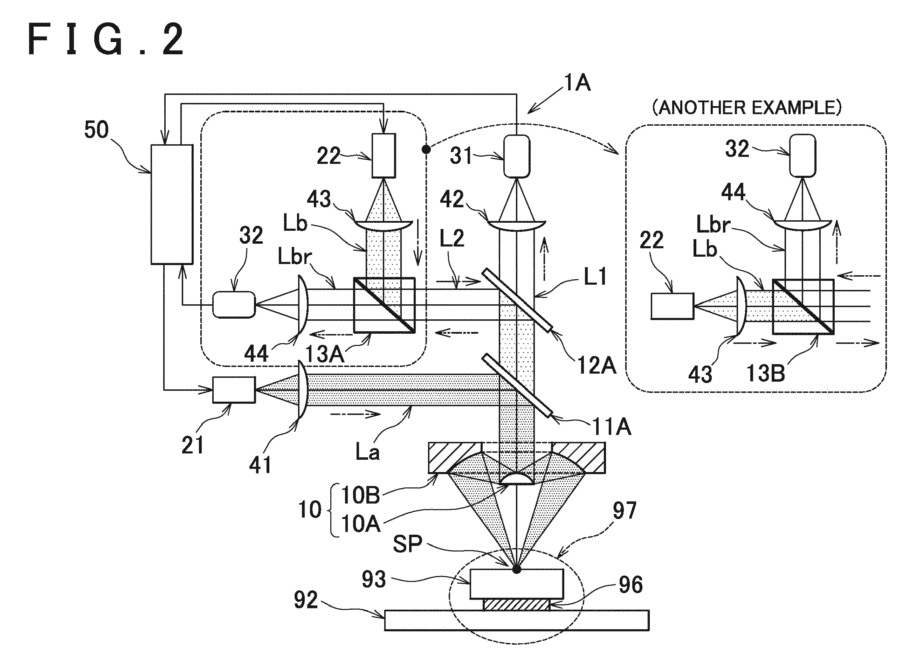

First, the configuration of the optical non-destructive inspection apparatus 1A according to the first embodiment will be described below with reference to FIG. 2. The optical non-destructive inspection apparatus 1A includes a focusing-collimating unit 10, a heating-laser selective reflection unit 11A, a predetermined-infrared selective reflection unit 12A, a beam splitter 13A, a heating laser beam source 21, a correcting laser beam source 22, an infrared detector 31, a correcting laser detector 32, a heating laser beam collimating unit 41, an infrared focusing unit 42, a correcting laser beam collimating unit 43, a reflected laser beam focusing unit 44, and a control unit 50.

The focusing-collimating unit 10 emits parallel light, which is incident from a first side (the upper side in an example in FIG. 2) along its own optical axis, from a second side (the lower side in FIG. 2) and focuses the parallel light to the measurement spot SP set on the measurement object as a focal position. The focusing-collimating unit 10 converts light emitted and reflected from the measurement spot SP and incident from the second side, into parallel light along the optical axis and emits the parallel light from the first side. The focusing-collimating unit 10 may be formed by using a focusing lens that transmits and refracts light. However, since light beams with plural different wavelengths are treated, a focusing lens causing chromatic aberration is not preferable. Therefore, by forming the focusing-collimating unit 10 using aspheric reflecting mirrors 10A and 10B, occurrence of chromatic aberration is prevented to cope with a broad wavelength band.

The heating laser beam source 21 emits a heating laser beam, whose output level is adjusted so that the heating laser beam heats the measurement object without destroying the measurement object, on the basis of a control signal from the control unit 50. The wavelength of the heating laser beam is referred to as a heating laser wavelength λa. The heating laser beam source 21 is, for example, a semiconductor laser.

The heating laser beam collimating unit 41 is disposed in the vicinity of the heating laser beam source 21, that is, in the vicinity of a laser beam emission position at a position on the optical axis of the heating laser beam, and converts the heating laser beam emitted from the heating laser beam source 21 into a heating laser beam La that is parallel light. For example, the heating laser beam collimating unit 41 needs to convert only a light beam with the heating laser wavelength λa into parallel light and thus may be a collimation lens. When the heating laser beam source 21 can emit a heating laser beam as parallel light, the heating laser beam collimating unit 41 may be omitted.

The heating-laser selective reflection unit 11A is disposed on the optical axis of the focusing-collimating unit 10 and reflects the heating laser beam La, which is obtained by converting the heating laser beam emitted from the heating laser beam source 21 into parallel light, to the first side of the focusing-collimating unit 10. The wavelength of the heating laser beam La is the heating laser wavelength λa. The heating-laser selective reflection unit 11A transmits parallel light with a wavelength different from the heating laser wavelength λa out of the parallel light emitted and reflected from the measurement spot SP and emitted from the first side of the focusing-collimating unit 10. For example, the heating-laser selective reflection unit 11A is a dichroic mirror that reflects the light beam with the heating laser wavelength λa and transmits the light beam with a wavelength other than the heating laser wavelength λa. A heating laser beam guide unit is constituted by the heating laser beam collimating unit 41 and the heating-laser selective reflection unit 11A, and the heating laser beam guide unit converts the heating laser beam emitted from the heating laser beam source 21 into parallel light and guides the parallel light to the first side of the focusing-collimating unit 10.

The infrared detector 31 can detect energy of an infrared light beam emitted from the measurement spot SP. For example, the infrared detector 31 is an infrared sensor. The detection signal from the infrared detector 31 is acquired by the control unit 50.

A predetermined-infrared selective reflection unit 12A is disposed in the path of the parallel light emitted from the first side of the focusing-collimating unit 10 and transmitted by the heating-laser selective reflection unit 11A, and is disposed on the optical axis of the focusing-collimating unit 10 in this embodiment. The parallel light is parallel light having a wavelength different from the heating laser wavelength. The predetermined-infrared selective reflection unit 12A transmits parallel light L1 that is an infrared light beam with a predetermined infrared wavelength λ1 out of the parallel light emitted from the first side of the focusing-collimating unit 10 and transmitted by the heating-laser selective reflection unit 11A, to the second infrared detector 31, and reflects parallel light L2 with a wavelength different from the predetermined infrared wavelength λ1. Therefore, the second infrared detector 31 detects only energy of the infrared light beam with the predetermined infrared wavelength λ1. For example, the predetermined-infrared selective reflection unit 12A is a dichroic mirror that transmits the light beam with the predetermined infrared wavelength λ1 and that reflects the light beam with a wavelength other than the predetermined infrared wavelength λ1.

The infrared focusing unit 42 is disposed in the vicinity of the infrared detector 31 and focuses parallel light which is an infrared light beam with a predetermined infrared wavelength λ1 transmitted by the predetermined-infrared selective reflection unit 12A, to a detection position of the infrared detector 31. For example, since the infrared focusing unit 42 needs to focus only the light beam with the predetermined infrared wavelength λ1, the infrared focusing unit 42 may be a focusing lens. An emitted-infrared guide unit is constituted by the heating-laser selective reflection unit 11A, the predetermined-infrared selective reflection unit 12A, and the infrared focusing unit 42. The emitted-infrared guide unit extracts the infrared light beam with the predetermined infrared wavelength λ1 out of the parallel light emitted from the measurement spot SP and emitted from the first side of the focusing-collimating unit 10 and guides the extracted infrared light beam to the infrared detector 31.

The correcting laser beam source 22 emits a correcting laser beam with a correcting laser wavelength λb on the basis of a control signal from the control unit 50. For example, the correcting laser beam source 22 is a semiconductor laser. The output power of the correcting laser beam is adjusted to output power sufficiently smaller than that of the heating laser beam. The output power of the correcting laser beam source 22 is adjusted so that the temperature to which the measurement spot SP is heated with the correcting laser beam does not affect the temperature to which the measurement spot SP is heated with the heating laser beam. The correcting laser wavelength λb is a wavelength different from the heating laser wavelength λa.

The correcting laser beam collimating unit 43 is disposed on an optical axis of the correcting laser beam at a position in the vicinity of the correcting laser beam source 22, that is, in the vicinity of a laser beam emission position, and converts the correcting laser beam emitted from the correcting laser beam source 22 into a correcting laser beam Lb as parallel light. For example, since the correcting laser beam collimating unit 43 needs to convert only the light beam with the correcting laser wavelength λb into parallel light, the correcting laser beam collimating unit 43 may be a collimating lens. When the correcting laser beam source 22 can emit the correcting laser beam as parallel light, the correcting laser beam collimating unit 43 may be omitted.

The beam splitter 13A reflects the light beam with the correcting laser wavelength λb, that is, the correcting laser beam emitted from the correcting laser beam source 22 and collimated into parallel light, at a first predetermined proportion, and transmits the correcting laser beam at a second predetermined proportion. The beam splitter 13A guides the correcting laser beam reflected at the first predetermined proportion, to the predetermined-infrared selective reflection unit 12A so that the correcting laser beam overlaps with the parallel light L2 with a wavelength different from the predetermined infrared wavelength. The correcting laser beam emitted from the correcting laser beam source 22 and transmitted at the second predetermined proportion by the beam splitter 13A is not used at all and is discarded.

A correcting laser beam guide unit is constituted by the correcting laser beam collimating unit 43, the beam splitter 13A, the predetermined-infrared selective reflection unit 12A, and the heating-laser selective reflection unit 11A. The correcting laser beam guide unit converts the correcting laser beam emitted from the correcting laser beam source 22 into parallel light, and guides the parallel light to the first side of the focusing-collimating unit 10.

The correcting laser detector 32 can detect energy of the correcting laser beam reflected from the measurement spot SP. For example, the correcting laser detector 32 is an optical sensor that can detect energy of the light beam with the correcting laser wavelength λb. The detection signal from the correcting laser detector 32 is acquired by the control unit 50. The beam splitter 13A transmits the correcting laser beam reflected from the measurement spot SP and reflected by the predetermined-infrared selective reflection unit 12A, toward the correcting laser detector 32 at the second predetermined proportion.

The reflected laser beam focusing unit 44 is disposed in the vicinity of the correcting laser detector 32. The reflected laser beam focusing unit 44 focuses parallel light Lbr with the correcting laser wavelength λb, to the detection position of the correcting laser detector 32. The parallel light Lbr is light obtained as a result of the correcting laser beam being reflected from the measurement spot SP, transmitted by the beam splitter 13A, and guided in a direction different from a direction toward the correcting laser beam source 22. Reflected light of the correcting laser beam reflected from the measurement spot SP and reflected by the beam splitter 13A is not used at all and is discarded. Since the reflected laser beam focusing unit 44 needs to focus only the light beam with the correcting laser wavelength λb, the reflected laser beam focusing unit 44 may be, for example, a focusing lens.

A reflected laser beam guide unit is constituted by the heating-laser selective reflection unit 11A, the predetermined-infrared selective reflection unit 12A, the beam splitter 13A, and the reflected laser beam focusing unit 44. The reflected laser beam guide unit guides the correcting laser beam reflected from the measurement spot SP and emitted from the first side of the focusing-collimating unit 10, to the correcting laser detector 32.

In the part surrounded with a dotted line in the left half of FIG. 2, the positions of the correcting laser beam source 22 and the correcting laser beam collimating unit 43, and the positions of the correcting laser detector 32 and the reflected laser beam focusing unit 44 may be interchanged as illustrated in the part surrounded with a dotted line and indicated by "another example". In this case, the beam splitter 13B transmits the correcting laser beam with the correcting laser wavelength λb emitted from the correcting laser beam source 22 and collimated into parallel light, at the first predetermined proportion, and reflects the correcting laser beam with the correcting laser wavelength λb at the second predetermined proportion. The beam splitter 13B guides the correcting laser beam transmitted at the first predetermined proportion, to the predetermined-infrared selective reflection unit 12A so that the correcting laser beam overlaps with the parallel light L2 with a wavelength different from the predetermined infrared wavelength. The beam splitter 13B reflects the correcting laser beam reflected from the measurement spot SP and reflected by the predetermined-infrared selective reflection unit 12A, toward the correcting laser detector 32 at the second predetermined proportion.

The control unit 50 is constituted by a personal computer or the like, controls the heating laser beam source 21 and the correcting laser beam source 22, and measures a temperature rise characteristic that is a temperature rise state of the measurement spot SP based on the heating time, on the basis of the detection signal from the infrared detector 31 and the detection signal from the correcting laser detector 32. The control unit 50 determines the state of the measurement object on the basis of the measured temperature rise characteristic. Detailed operations of the control unit 50 will be described later.

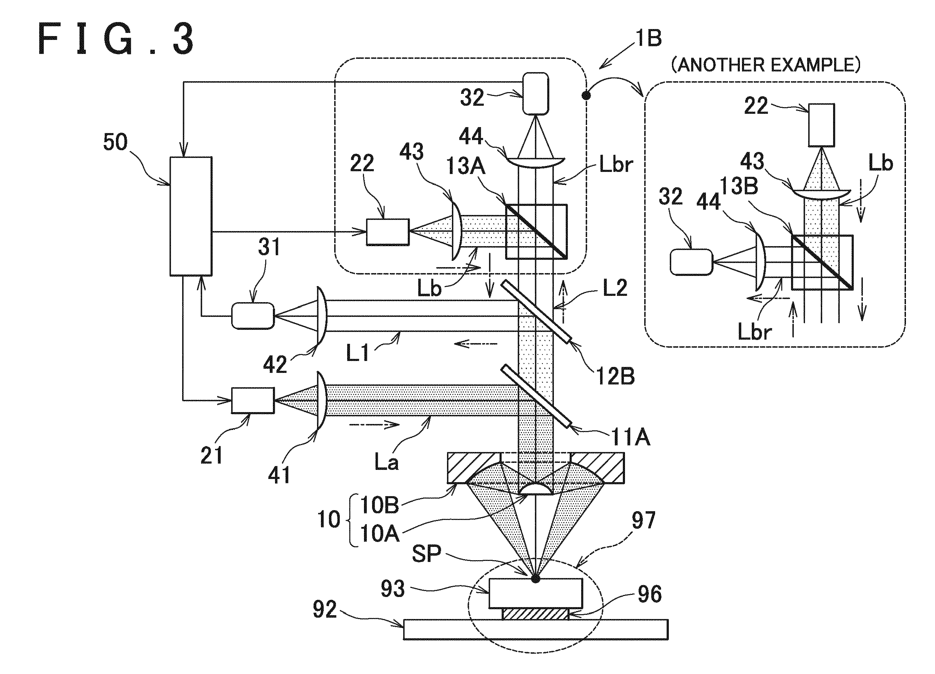

The configuration of an optical non-destructive inspection apparatus 1B according to the second embodiment will be described below with reference to FIG. 3. Differences from the optical non-destructive inspection apparatus 1A according to the first embodiment will be mainly described. The optical non-destructive inspection apparatus 1B according to the second embodiment is different from the optical non-destructive inspection apparatus 1A according to the first embodiment, in the operation of a predetermined-infrared selective reflection unit 12B and the arrangements of the infrared detector 31, the correcting laser beam source 22, and the correcting laser detector 32.

The predetermined-infrared selective reflection unit 12B is the same as the predetermined-infrared selective reflection unit 12A, in that the predetermined-infrared selective reflection unit 12B is disposed in the path of the parallel light that is emitted from the first side of the focusing-collimating unit 10 and transmitted by the heating-laser selective reflection unit 11A and has a wavelength different from the heating laser wavelength. The predetermined-infrared selective reflection unit 12B is disposed on the optical axis of the focusing-collimating unit 10. However, the predetermined-infrared selective reflection unit 12B is different from the predetermined-infrared selective reflection unit 12A, in that the predetermined-infrared selective reflection unit 12B reflects the parallel light L1 as the infrared light beam with the predetermined infrared wavelength λ1 out of the parallel light emitted from the first side of the focusing-collimating unit 10 and transmitted by the heating-laser selective reflection unit 11A, toward the infrared detector 31 (the predetermined-infrared selective reflection unit 12A transmits the parallel light L1). The predetermined-infrared selective reflection unit 12B transmits the parallel light L2 with a wavelength different from the predetermined infrared wavelength λ1 (The predetermined-infrared selective reflection unit 12A reflects the parallel light L2). For example, the predetermined-infrared selective reflection unit 12B is a dichroic mirror that reflects the light beam with the predetermined infrared wavelength λ1 and transmits the light beam with a wavelength other than the predetermined infrared wavelength λ1.

Accordingly, the infrared focusing unit 42 and the infrared detector 31 are disposed at the reflection destination of the predetermined-infrared selective reflection unit 12B. The beam splitter 13A, the correcting laser beam collimating unit 43, the correcting laser beam source 22, the reflected laser beam focusing unit 44, and the correcting laser detector 32 are disposed at the transmission destination of the predetermined-infrared selective reflection unit 12B. The correcting laser beam emitted from the correcting laser beam source 22 is guided to the predetermined-infrared selective reflection unit 12B by the beam splitter 13A so as to overlap with the parallel light L2 with a wavelength different from the predetermined laser wavelength, and is transmitted by the predetermined-infrared selective reflection unit 12B and guided to the heating-laser selective reflection unit 11A. The correcting laser beam reflected from the measurement spot SP is transmitted by the predetermined-infrared selective reflection unit 12B and guided to the beam splitter 13A.

In the part surrounded with a dotted line in the upper center of FIG. 3, the positions of the correcting laser beam source 22 and the correcting laser beam collimating unit 43, and the positions of the correcting laser detector 32 and the reflected laser beam focusing unit 44 may be interchanged as illustrated in the part surrounded with a dotted line and indicated by "another example". In this case, the beam splitter 13B transmits the correcting laser beam with the correcting laser wavelength λb emitted from the correcting laser beam source 22 and collimated into parallel light, at the first predetermined proportion, and reflects the correcting laser beam with the correcting laser wavelength λb at the second predetermined proportion. The beam splitter 13B guides the correcting laser beam transmitted at the first predetermined proportion, to the predetermined-infrared selective reflection unit 12B so that the correcting laser beam overlaps with the parallel light L2 with a wavelength different from the predetermined infrared wavelength. The beam splitter 13B reflects the correcting laser beam reflected from the measurement spot SP and transmitted by the predetermined-infrared selective reflection unit 12B, toward the correcting laser detector 32 at the second predetermined proportion.

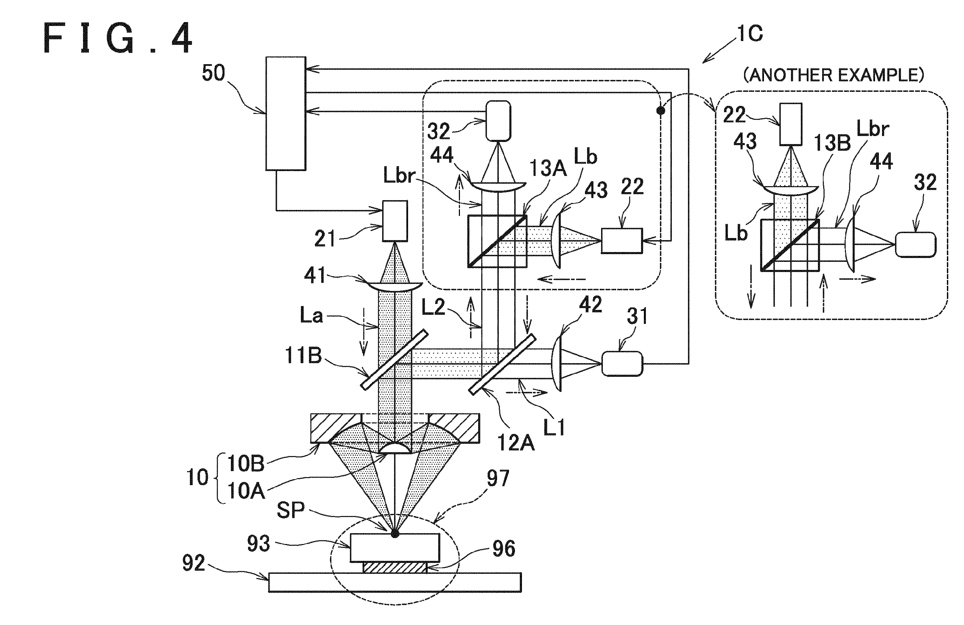

The configuration of an optical non-destructive inspection apparatus 1C according to the third embodiment will be described below with reference to FIG. 4. Differences from the optical non-destructive inspection apparatus 1A according to the first embodiment will be mainly described. The optical non-destructive inspection apparatus 1C according to the third embodiment is different from the optical non-destructive inspection apparatus 1A according to the first embodiment, in the operation of a heating-laser selective reflection unit 11B and the arrangement of the heating laser beam source 21.

The heating-laser selective reflection unit 11B is disposed on the optical axis of the focusing-collimating unit 10 and transmits the heating laser beam La with the heating laser wavelength λa, which is obtained by converting the heating laser beam emitted from the heating laser beam source 21 into parallel light, to the first side of the focusing-collimating unit 10 (the heating-laser selective reflection unit 11A reflects the heating laser beam La). In addition, the heating-laser selective reflection unit 11B reflects parallel light with a wavelength different from the heating laser wavelength λa that is emitted and reflected from the measurement spot SP and emitted from the first side of the focusing-collimating unit 10 (the heating-laser selective reflection unit 11A transmits the parallel light). For example, the heating-laser selective reflection unit 11B is a dichroic mirror that transmits the light beam with the heating laser wavelength λa and reflects the light beam with a wavelength other than the heating laser wavelength λa. The parallel light reflected by the heating-laser selective reflection unit 11B is treated in the same manner as in the first embodiment, and will not be repeatedly described.

In the part surrounded with a dotted line in the upper center of FIG. 4, the positions of the correcting laser beam source 22 and the correcting laser beam collimating unit 43, and the positions of the correcting laser detector 32 and the reflected laser beam focusing unit 44 may be interchanged as illustrated in the part surrounded with a dotted line and indicated by "another example". In this case, the beam splitter 13B transmits the correcting laser beam with the correcting laser wavelength λb emitted from the correcting laser beam source 22, at the first predetermined proportion, and reflects the correcting laser beam of the correcting laser wavelength λb at the second predetermined proportion. The beam splitter 13B guides the correcting laser beam as the parallel light transmitted at the first predetermined proportion, to the predetermined-infrared selective reflection unit 12A so that the correcting laser beam overlaps with the parallel light L2 with a wavelength different from the predetermined infrared wavelength. The beam splitter 13B reflects the correcting laser beam reflected from the measurement spot SP and reflected by the predetermined-infrared selective reflection unit 12A, toward the correcting laser detector 32 at the second predetermined proportion.

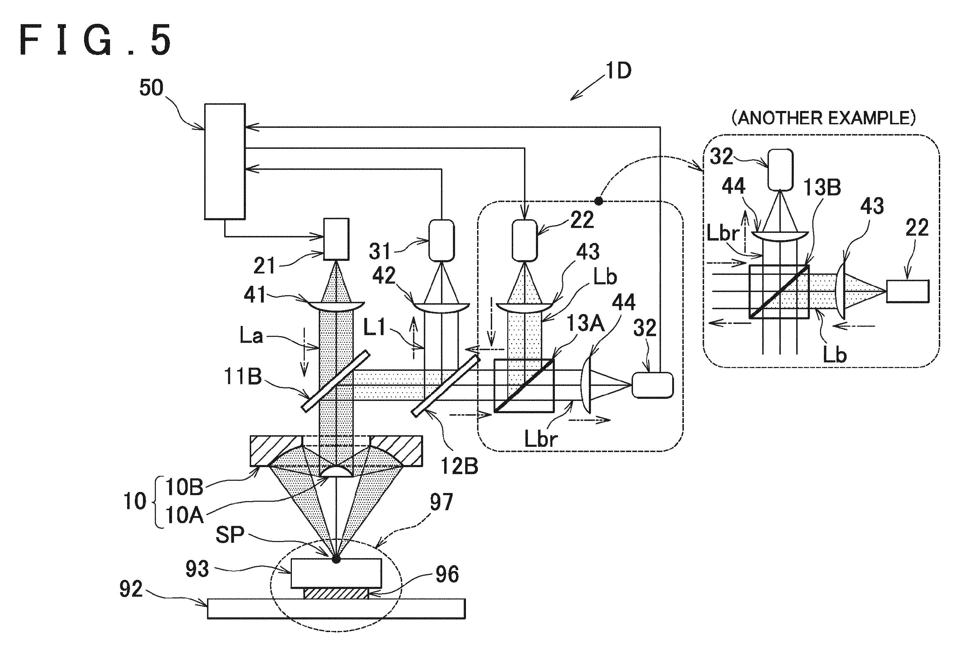

The configuration of an optical non-destructive inspection apparatus 1D according to the fourth embodiment will be described below with reference to FIG. 5. Differences from the optical non-destructive inspection apparatus 1B according to the second embodiment will be mainly described. The optical non-destructive inspection apparatus 1D according to the fourth embodiment is different from the optical non-destructive inspection apparatus 1B according to the second embodiment, in the operation of a heating-laser selective reflection unit 11B and the arrangement of the heating laser beam source 21.

As is the case with the third embodiment, the heating-laser selective reflection unit 11B is disposed on the optical axis of the focusing-collimating unit 10 and transmits the heating laser beam La with the heating laser wavelength λa, which is obtained by converting the heating laser beam emitted from the heating laser beam source 21 into parallel light, to the first side of the focusing-collimating unit 10 (the heating-laser selective reflection unit 11A reflects the heating laser beam La). In addition, the heating-laser selective reflection unit 11B reflects parallel light with a wavelength different from the heating laser wavelength λa, which is emitted and reflected from the measurement spot SP and emitted from the first side of the focusing-collimating unit 10 (the heating-laser selective reflection unit 11A transmits the parallel light). For example, the heating-laser selective reflection unit 11B is a dichroic mirror that transmits the light beam with the heating laser wavelength λa and reflects the light beam with a wavelength other than the heating laser wavelength λa. The parallel light with a wavelength other than the heating laser wavelength λa reflected by the heating-laser selective reflection unit 11B is treated in the same manner as in the first embodiment, and will not be repeatedly described.

In the part surrounded with a dotted line in the middle center of FIG. 5, the positions of the correcting laser beam source 22 and the correcting laser beam collimating unit 43, and the positions of the correcting laser detector 32 and the reflected laser beam focusing unit 44 may be interchanged as illustrated in the part surrounded with a dotted line and indicated by "another example". In this case, the beam splitter 13B transmits the correcting laser beam with the correcting laser wavelength λb emitted from the correcting laser beam source 22 and collimated into parallel light, at the first predetermined proportion, and reflects the correcting laser beam with the correcting laser wavelength λb at the second predetermined proportion. The beam splitter 13B guides the correcting laser beam transmitted at the first predetermined proportion, to the predetermined-infrared selective reflection unit 12B so that the correcting laser beam overlaps with the parallel light L2 with a wavelength different from the predetermined infrared wavelength. The beam splitter 13B reflects the correcting laser beam reflected from the measurement spot SP and transmitted by the predetermined-infrared selective reflection unit 12B, to the correcting laser detector 32 at the second predetermined proportion.

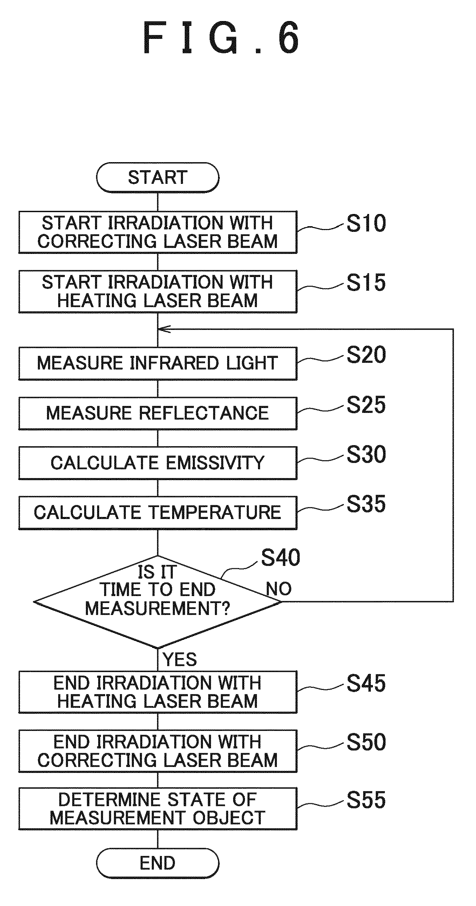

The procedure of first processing performed by the control unit 50 will be described below with reference to the flowchart illustrated in FIG. 6. The configuration of the optical non-destructive inspection apparatus may be the configuration in any one of the first to fourth embodiments. The processing illustrated in FIG. 6 is performed by the control unit 50 when the measurement spot is inspected.

In step S 10, the control unit 50 controls the correcting laser beam source so that the correcting laser beam is emitted from the correcting laser beam source, and then performs the process of step S 15. The correcting laser beam is guided to the measurement spot and the correcting laser beam emitted from the measurement spot is guided to the correcting laser detector.

In step S15, the control unit 50 controls the heating laser beam source so that a heating laser beam is emitted from the heating laser beam source, and then performs the process of step S20. The heating laser beam is guided to the measurement spot and the infrared light beam emitted from the measurement spot is guided to the infrared detector.

In step S20, the control unit 50 detects energy of the infrared light beam with the predetermined infrared wavelength λ1 based on the detection signal from the infrared detector, acquires and temporarily stores the detected energy of the infrared light beam with the predetermined infrared wavelength λ1 and the time after irradiation with the heating laser beam is started in step S15, and then performs the process of step S25.

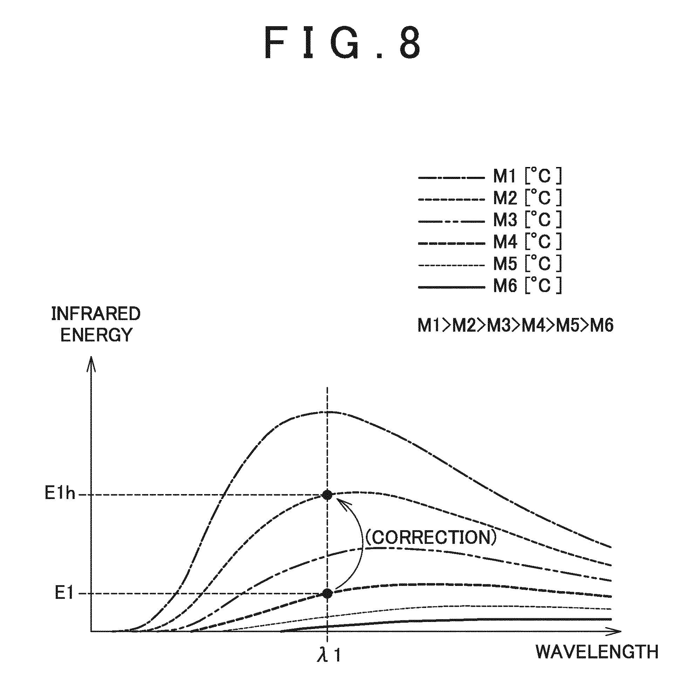

FIG. 8 illustrates an example of an infrared emission characteristic representing the relationship between the wavelength of the infrared light beam radiated from a black body (indicated by the horizontal axis) and energy of the infrared light beam with the corresponding wavelength (indicated by the vertical axis) when the temperature of the black body completely absorbing and radiating irradiated light is each of temperatures (M1, M2, M3, M4, M5, and M6). For example, in a case where the measurement spot is a block body, the position of the detected predetermined infrared wavelength λ1 is the position of λ1 illustrated in FIG. 8, and the detected infrared energy is E1, it is determined that the temperature of the measurement spot is M4 (°C). However, since the actual measurement spot is not a black body and thus does not absorb the whole heating laser beam that is applied, and reflects a part thereof, correction needs to be performed. The energy of the infrared light beam detected in step S20 is corrected in subsequent steps S25 to S35.

In step S25, the control unit 50 measures the reflectance of the correcting laser beam on the basis of the detection signal from the correcting laser detector, and then performs the process of step S30. For example, the control unit 50 measures the reflectance of the measurement spot on the basis of the energy of the correcting laser beam from the correcting laser beam source, the reflectance and transmittance of the beam splitter, and the energy of the light beam with the correcting laser wavelength detected by the correcting laser detector.

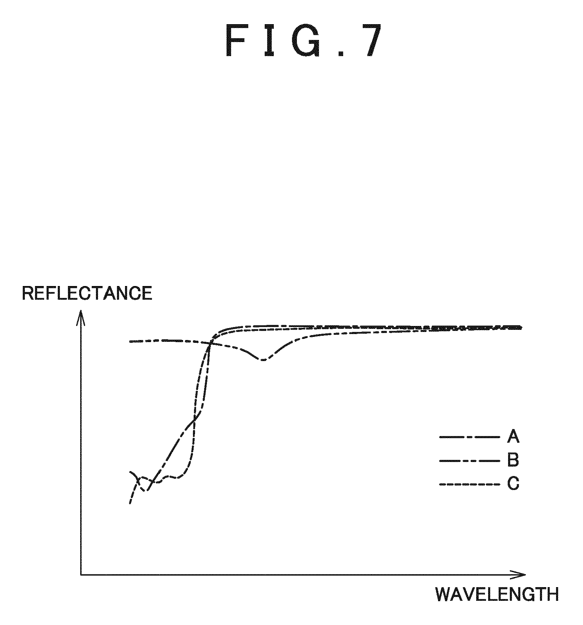

FIG. 7 illustrates an example of a reflectance characteristic representing the relationship between the wavelength (indicated by the horizontal axis) of an applied light beam and the reflectance (indicated by the vertical axis) in a material A, a material B, and a material C, each of which has a surface in a predetermined surface state. As illustrated in FIG. 7, the reflectance varies depending on the material of an object or the wavelength of the applied light beam and varies depending on the surface state (for example, density or depth of fine unevenness) of the object. Therefore, it is necessary to measure the reflectance for each measurement spot.

In step S30, the control unit 50 calculates emissivity from the reflectance measured in step S25, and then performs the process of step S35. Specifically, the emissivity is calculated on the basis of the relationship of emissivity (%) = absorptance (%) = 100 (%) - reflectance (%).

In step S35, the control unit 50 corrects the infrared energy (which corresponds to the detected value of infrared energy) temporarily stored in step S20 on the basis of the emissivity calculated in step S30 and then performs the process of step S40. For example, it is assumed that when the infrared energy temporarily stored in step S20 is E1 illustrated in FIG. 8, the result of correcting the infrared energy E1 using the emissivity calculated in step S30 is E1h. In this case, the correct temperature of the measurement spot is M2 (°C) (corrected temperature) corresponding to the corrected energy E1h instead of M4 (°C) (actual temperature) corresponding to E1. The actual temperature means a temperature based on the actually-measured infrared energy. The corrected temperature means a temperature based on the corrected infrared energy. The infrared emission characteristic shown in the example in FIG. 8 is stored in advance in a storage unit, and the control unit 50 determines the temperature (M2 (°C) in this case) of the measurement spot on the basis of the infrared emission characteristic stored in the storage unit and the detected and corrected infrared energy (the energy E1h in this case).

Then, the control unit determines the temperature rise characteristic shown in the example in FIG. 9 on the basis of the time (corresponding to the heating time) after the irradiation is started, which is stored in step S20, and the corrected temperature corresponding to the time. For example, a case where the time after the irradiation is started is T1, the actual temperature is M4 (°C), and the corrected temperature is M2 (°C) is illustrated in FIG. 9. The control unit needs to determine only the temperature rise characteristic based on the corrected temperature and may not particularly determine the temperature rise characteristic based on the actual temperature.

In step S40, the control unit 50 determines whether it is time to end the measurement. The control unit 50 determines that it is time to end the measurement when it is determined that the determined corrected temperature reaches a saturated temperature. For example, when a temperature rising value, by which the corrected temperature currently determined in step S35 is higher than the corrected temperature previously determined in step S35 is equal to or less than a predetermined value, the control unit 50 determines that the corrected temperature reaches the saturated temperature. The saturated temperature is a temperature when the inclination of the temperature rise characteristic illustrated in FIG. 9 is equal to or less than a predetermined value. After the corrected temperature reaches the saturated temperature, the corrected temperature is almost constant.

The control unit 50 performs the process of step S45 when it is determined that the corrected temperature reaches the saturated temperature and it is time to end the measurement (YES), and performs the process of step S20 again when it is determined that it is not time to end the measurement (NO). When the processing returns to step S20 after a predetermined time (for example, about 1 ms) passes, the corrected temperature can be determined at predetermined time intervals, which is preferable.

In step S45, the control unit 50 controls the heating laser beam source so as to stop the irradiation with the heating laser beam, and then performs the process of step S50. In step S50, the control unit 50 controls the correcting laser beam source so as to stop the irradiation with the correcting laser beam, and then perform the process of step S55.

In step S55, the control unit 50 determines the state of the measurement object on the basis of the temperature rise characteristic that is based on the corrected temperature determined in step S35, displays the determination result on a display device or the like, and then finishes the processing. FIG. 10 illustrates an example of the temperature rise characteristic (indicated by a dotted line in FIG. 10) when the area of the bonding part 96 in FIG. 1 is equal to an ideal area, an example of the temperature rise characteristic (indicated by an alternate long and short dash line in FIG. 10) when the area of the bonding part 96 is equal to a lower-limit area, and an example of the temperature rise characteristic (indicated by an alternate long and two short dashes line in FIG. 10) when the area of the bonding part 96 is equal to an upper-limit area. For example, the lower-limit-area temperature rise characteristic when the area of the bonding part 96 is equal to the lower-limit area and the upper-limit area temperature rise characteristic when the area of the bonding part 96 is equal to the upper-limit area are stored in the storage unit.

In step S55, the control unit 50 determines whether the temperature rise characteristic determined based on the corrected temperature lies between the lower-limit-area temperature rise characteristic and the upper-limit-area temperature rise characteristic stored in the storage unit. The control unit 50 determines that the bonding state is appropriate when it is determined that the temperature rise characteristic lies between the lower-limit-area temperature rise characteristic and the upper-limit-area temperature rise characteristic, determines that the bonding state is inappropriate when the temperature rise characteristic does not lie between the lower-limit-area temperature rise characteristic and the upper-limit-area temperature rise characteristic, and displays the determination result. When the temperature rise characteristic determined based on the corrected temperature lies between the lower-limit-area temperature rise characteristic and the upper-limit-area temperature rise characteristic, the area of the bonding part is between the lower-limit area and the upper-limit-area, that is, the area of the bonding part is in an allowable range.

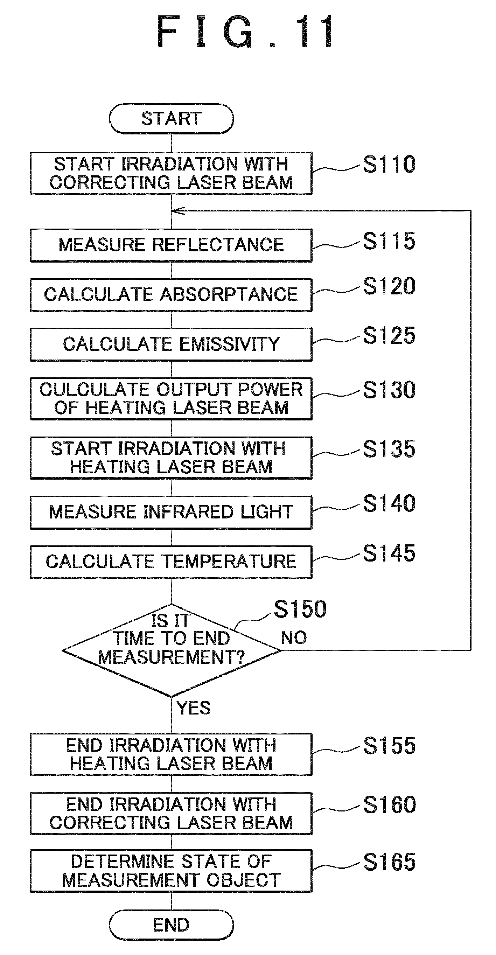

An example of the procedure of second processing performed by the control unit 50 will be described below with reference to the flowchart illustrated in FIG. 11. The configuration of the optical non-destructive inspection apparatus may be the same as that in any one of the first to fourth embodiments. In the above-mentioned procedure of the first processing, the measured infrared energy is corrected on the basis of the reflectance, and the temperature rise characteristic is determined on the basis of the corrected temperature calculated from the corrected infrared energy and the time after the heating is started. However, in the procedure of the second processing to be described below, the output power of the heating laser beam is adjusted (increased) on the basis of the reflectance so that the measured infrared energy is equal to the corrected infrared energy.

In step S110, the control unit 50 controls the correcting laser beam source so that the correcting laser beam is emitted from the correcting laser beam source, and then performs the process of step S 115. The correcting laser beam is guided to a measurement spot, and the correcting laser beam reflected from the measurement spot is guided to the correcting laser detector.

In step S115, the control unit 50 measures the reflectance of the correcting laser beam on the basis of the detection signal from the correcting laser detector, and then performs the process of step S120. The method of measuring the reflectance is the same as described above.

In step S120, the control unit 50 calculates absorptance from the reflectance measured in step S115, and then performs the process of step S125. Specifically, the absorptance is calculated on the basis of the relationship of absorptance (%) = 100 (%) - reflectance (%).

In step S125, the control unit 50 calculates emissivity from the absorptance calculated in step S120, and then performs the process of step S130. Specifically, the emissivity is calculated on the basis of the relationship of absorptance (%) = emissivity (%).

In step S 130, the control unit 50 calculates an output value to be output from the heating laser beam source on the basis of the absorptance calculated in step S120, and then performs the process of step S135. For example, in a case where it is estimated, from the relationship with the absorptance, that the infrared energy E1 in FIG. 8 is detected if the heating laser beam with output power of W1 is emitted, the output power W1h of the heating laser beam is calculated on the basis of the absorptance so that the detected infrared energy becomes E1h.

In step S 135, the control unit 50 controls the heating laser beam source so that the heating laser beam with the output value calculated in step S 130 is emitted, and then performs the process of step S140. In step S140, the control unit 50 detects the energy of the infrared light beam with the predetermined infrared wavelength λ1 on the basis of the detection signal from the infrared detector, acquires and stores the detected energy of the infrared light beam with the predetermined infrared wavelength λ1 and the time after the irradiation with the heating laser beam is started, and then performs the process of step S145.

In step S145, the control unit 50 determines the temperature (actual temperature) corresponding to the acquired infrared energy, determines the temperature rise characteristic on the basis of the determined actual temperature and the time after the irradiation is started, and then performs the process of step S150. In this case, since the output power of the heating laser beam is adjusted (increased) on the basis of the absorptance, the determined actual temperature can be directly used as the temperature rise characteristic.

In step S150, the control unit 50 determines whether it is time to end the measurement. As described above, the control unit 50 determines that it is time to end the measurement when it is determined that the determined temperature reaches a saturated temperature. The control unit 50 performs the process of step S 155 when it is determined that the determined temperature reaches the saturated temperature and it is time to end the measurement (YES), and performs the process of step S115 again when it is determined that it is not time to end the measurement (NO). When the processing returns to step S115 after a predetermined time (for example, about 1 ms) passes, the actual temperature can be measured at predetermined time intervals, which is preferable.

In step S155, the control unit 50 controls the heating laser beam source so as to stop the irradiation with the heating laser beam, and then performs the process of step S160. In step S160, the control unit 50 controls the correcting laser beam source so as to stop the irradiation with the correcting laser beam, and then perform the process of step S165. In step S165, the control unit 50 determines the state of the measurement object on the basis of the temperature rise characteristic that is based on the actual temperature determined in step S145, displays the determination result on a display device or the like, and ends the processing.

The method of determining the state of the measurement object is the same as that described above. For example, a lower-limit-area temperature rise characteristic when the area of the bonding part 96 is equal to the lower-limit area and an upper-limit-area temperature rise characteristic when the area of the bonding part 96 is equal to the upper-limit-area are stored in the storage unit. In step S165, the control unit 50 determines whether the temperature rise characteristic determined based on the actual temperature lies between the lower-limit-area temperature rise characteristic and the upper-limit-area temperature rise characteristic stored in the storage unit as illustrated in FIG. 10. When the temperature rise characteristics lies between the lower-limit-area temperature rise characteristic and the upper-limit-area temperature rise characteristic, it is determined that the bonding state is appropriate. When the temperature rise characteristic does not lie between the lower-limit-area temperature rise characteristic and the upper-limit-area temperature rise characteristic, it is determined that the bonding state is inappropriate. The control unit 50 displays the determination result. When the temperature rise characteristic determined on the basis of the actual temperature is present between the lower-limit-area temperature rise characteristic and the upper-limit-area temperature rise characteristic, the area of the bonding part is between the lower-limit area and the upper-limit-area, that is, the area of the bonding part is in an allowable range.

A method in which the procedure of the first processing or the procedure of the second processing is performed by using the above-mentioned optical non-destructive inspection apparatus according to each of the first to fourth embodiments may be used as an optical non-destructive inspection method for determining the state of the bonding structure 97 as a measurement object or the bonding state of two members (the wire 93 and the electrode 92) or determining whether the area of the bonding part of two members (the wire 93 and the electrode 92) is in an allowable range, by using a control unit.

Since the optical non-destructive inspection apparatus described in each of the above-mentioned embodiments determines the state of the measurement object using the temperature rise characteristic in a period of several tens of ms until the temperature reaches the saturated temperature after the heating is started with the heating laser beam, the inspection time is extremely short as compared to the case (several tens of seconds to several minutes) in which the state is determined using the heat-dissipation state after heating. Since the reflectance is measured and used to perform the correction, inspection can be performed by using one wavelength (the predetermined infrared wavelength λ1) of the infrared light beam, as compared to a case where a ratio of infrared light beams with two different wavelengths is used. Therefore, the wavelength of the infrared light beam to be measured can be selected from among options in a broad range, and thus, it is possible to measure a broader temperature range.

Each of the above-mentioned embodiments can be used to determine whether the bonding state of a wire-bonding portion or the like is appropriate. Thus, it is possible to perform inspection with higher reliability, as compared to an operator's visual inspection or destructive inspection of an extracted sample. Since the correcting laser beam itself reflected from the measurement spot is detected without heating the measurement spot with the correcting laser beam, the reflectance of the measurement spot is measured, and the temperature is corrected on the basis of the measured reflectance, it is possible to obtain a more accurate temperature rise characteristic.

Various modifications, additions, or deletions may be made to the configuration, structure, appearance, shape, processing procedure and the like of the optical non-destructive inspection apparatus and the optical non-destructive inspection method, without departing from the scope of the present invention.

## Claims

1. An optical non-destructive inspection apparatus comprising:
a focusing-collimating unit that that emits parallel light, which is incident from a first side along an optical axis, from a second side, focuses the parallel light to a measurement spot set on a measurement object as a focal position, converts light, which is emitted and reflected from the measurement spot and incident from the second side, into parallel light along the optical axis, and emits the parallel light from the first side;
a heating laser beam source that emits a heating laser beam for heating the measurement object without destroying the measurement object;
a heating laser beam guide unit that guides the heating laser beam to the first side of the focusing-collimating unit;
an infrared detector that detects an infrared light beam emitted from the measurement spot;
an emitted-infrared guide unit that guides an infrared light beam with a predetermined infrared wavelength out of the parallel light emitted from the measurement spot and emitted from the first side of the focusing-collimating unit, to the infrared detector;
a correcting laser beam source that emits a correcting laser beam having output power smaller than that of the heating laser beam, and having a correcting laser wavelength different from a heating laser wavelength of the heating laser beam;
a correcting laser beam guide unit that guides the correcting laser beam to the first side of the focusing-collimating unit;
a correcting laser detector that detects the correcting laser beam reflected by the measurement spot;
a reflected laser beam guide unit that guides the correcting laser beam reflected by the measurement spot and emitted from the first side of the focusing-collimating unit, to the correcting laser detector; and
a control unit,
wherein the control unit controls the heating laser beam source and the correcting laser beam source, measures a temperature rise characteristic based on a detection signal from the infrared detector and a detection signal from the correcting laser detector, and determines a state of the measurement object based on the measured temperature rise characteristic, the temperature rise characteristic being a temperature rise state of the measurement spot based on a heating time.

2. The optical non-destructive inspection apparatus according to claim 1, wherein
the heating laser beam guide unit includes:
a heating laser beam collimating unit that is disposed in vicinity of the heating laser beam source, and converts the heating laser beam emitted from the heating laser beam source into parallel light; and
a heating-laser selective reflection unit that is disposed on the optical axis of the focusing-collimating unit, reflects the heating laser beam to the first side of the focusing-collimating unit, and transmits a light beam with a wavelength different from the heating laser wavelength of the heating laser beam out of the parallel light emitted and reflected from the measurement spot and emitted from the first side of the focusing-collimating unit; or
a heating-laser selective reflection unit that is disposed on the optical axis of the focusing-collimating unit, transmits the heating laser beam to the first side of the focusing-collimating unit, and reflects the light beam with the wavelength different from the heating laser wavelength of the heating laser beam out of the parallel light emitted and reflected from the measurement spot and emitted from the first side of the focusing-collimating unit.

3. The optical non-destructive inspection apparatus according to claim 2, wherein
the emitted-infrared guide unit includes:
the heating-laser selective reflection unit;
a predetermined-infrared selective reflection unit that is disposed in a path of parallel light that is emitted from the first side of the focusing-collimating unit and transmitted or reflected by the heating-laser selective reflection unit and has a wavelength different from the heating laser wavelength of the heating laser beam, the predetermined-infrared selective reflection unit transmitting the infrared light beam with the predetermined infrared wavelength out of the parallel light toward the infrared detector, and reflecting the parallel light with a wavelength different from the predetermined infrared wavelength, or
a predetermined-infrared selective reflection unit disposed in the path of the parallel light that is emitted from the first side of the focusing-collimating unit and transmitted or reflected by the heating-laser selective reflection unit and has the wavelength different from the heating laser wavelength, the predetermined-infrared selective reflection unit reflecting the infrared light beam with the predetermined infrared wavelength out of the parallel light toward the infrared detector, and transmitting the parallel light with the wavelength different from the predetermined infrared wavelength; and
an infrared focusing unit that is disposed in vicinity of the infrared detector, and focuses the infrared light beam with the predetermined infrared wavelength transmitted or reflected by the predetermined-infrared selective reflection unit, to the infrared detector, the infrared light beam with the predetermined infrared wavelength being parallel light.

4. The optical non-destructive inspection apparatus according to claim 3, wherein
the correcting laser beam guide unit includes:
a correcting laser beam collimating unit that is disposed in vicinity of the correcting laser beam source, and converts the correcting laser beam emitted from the correcting laser beam source into parallel light;
a beam splitter that reflects a light beam with the correcting laser wavelength at a predetermined first proportion, transmits the light beam with the correcting laser wavelength at a predetermined second proportion, and reflects or transmits the correcting laser beam with the correcting laser wavelength, which is emitted from the correcting laser beam source and converted into the parallel light, toward the predetermined-infrared selective reflection unit so that the correcting laser beam with the correcting laser wavelength overlaps with parallel light with a wavelength different from the predetermined infrared wavelength;
the predetermined-infrared selective reflection unit; and
the heating-laser selective reflection unit, and
wherein the reflected laser beam guide unit includes:
the heating-laser selective reflection unit;
the predetermined-infrared selective reflection unit;
the beam splitter; and
a reflected laser beam focusing unit that is disposed in vicinity of the correcting laser detector, and focuses a light beam with the correcting laser wavelength reflected from the measurement spot and transmitted or reflected by the beam splitter in a direction different from a direction toward the correcting laser beam source, to the correcting laser detector.

5. The optical non-destructive inspection apparatus according to any one of claims 1 to 4, wherein the control unit
acquires the detection signal from the infrared detector while controlling the heating laser beam source so as to heat the measurement spot with the heating laser beam,
acquires the detection signal from the correcting laser detector while controlling the correcting laser beam source so as to irradiate the measurement spot with the correcting laser beam,
measures a reflectance of the measurement spot based on the detection signal acquired from the correcting laser detector,
corrects a detected value acquired from the infrared detector based on the measured reflectance,
determines a temperature based on the corrected detected value, and
determines the state of the measurement object based on the temperature rise characteristic that is based on the determined temperature and the heating time.

6. The optical non-destructive inspection apparatus according to any one of claims 1 to 4, wherein the control unit
acquires the detection signal from the correcting laser detector while controlling the correcting laser beam source so as to irradiate the measurement spot with the correcting laser beam,
measures a reflectance of the measurement spot based on the detection signal acquired from the correcting laser detector,
adjusts output power of the heating laser beam from the heating laser beam source based on the measured reflectance,
acquires the detection signal from the infrared detector while heating the measurement spot with the heating laser beam whose output power has been adjusted,
determines a temperature based on the detection signal acquired from the infrared detector, and
determines the state of the measurement object based on the temperature rise characteristic that is based on the determined temperature and the heating time.

7. The optical non-destructive inspection apparatus according to any one of claims 1 to 6,
wherein the measurement object is a bonding structure including a bonding part in which two members are bonded,
wherein the measurement spot is set on a surface of one member of the two members, and
wherein the control unit determines a bonding state of the two members based on the temperature rise characteristic.

8. The optical non-destructive inspection apparatus according to claim 7,
wherein the bonding state of the two members to be determined is a magnitude of an area of the bonding part of the two members, and
wherein the control unit determines whether the area of the bonding part of the two members is in an allowable range, based on the temperature rise characteristic.

9. An optical non-destructive inspection method,
wherein the optical non-destructive inspection apparatus according to any one of claims 1 to 8 is used, and
wherein the state of the measurement object is determined by the control unit.
